# DEMANDE DE BREVET EUROPEEN

(11) **EP 4 521 888 A1**
(43) Date de publication de la demande: **12.03.2025**
(21) Numéro de dépôt: 24198338.6
(22) Date de dépôt: 04.09.2024
(51) Int. Cl.: H10F 77/30, H10F 71/00, C23C 14/04, C23C 16/44

(54) **DISPOSITIF ET PROCÉDÉ DE MAINTIEN D'UNE CELLULE PHOTOVOLTAÏQUE, DISPOSITIF DE DEPOT DE COUCHES MINCES ET PROCÉDÉ DE PASSIVATION D'UNE CELLULE PHOTOVOLTAÏQUE**

(30) Priorité: 05.09.2023 FR 2309299
(71) Demandeur: Commissariat à l'Energie Atomique et aux Energies Alternatives, 75015 Paris (FR)
(72) Inventeur: MARTEL, Benoît, 38054 GRENOBLE CEDEX 09 (FR); ALBARIC, Mickaël, 38054 GRENOBLE CEDEX 09 (FR); HARRISON, Samuel, 38054 GRENOBLE CEDEX 09 (FR)
(74) Mandataire: Cabinet Camus Lebkiri

(57) **Abrégé**

L'invention concerne un dispositif de maintien (1) d'une cellule photovoltaïque (5) pour former une couche de passivation sur ladite cellule photovoltaïque, la cellule photovoltaïque comprenant une première face (5A), une deuxième face (5B) et un bord périphérique (5C) reliant la première face et la deuxième face, le dispositif comprenant :
- une première partie de support (10) comprenant une première face de support (10A) et une deuxième face de support (10B), la première face de support étant munie d'un premier joint d'étanchéité (15) conformé selon un pourtour de la cellule photovoltaïque,
- une deuxième partie de support (20) comprenant une troisième face de support (20A) et une quatrième face de support (20B), la troisième face de support étant munie d'un deuxième joint d'étanchéité (25) conformé selon le pourtour de la cellule photovoltaïque, et
- des moyens de compression (30A, 30B) configurés pour maintenir la cellule photovoltaïque en appui serré contre le premier joint d'étanchéité et contre le deuxième joint d'étanchéité.

## Description

### DOMAINE TECHNIQUE

La présente invention concerne de manière générale la fabrication de cellules photovoltaïques.

L'invention concerne plus particulièrement un dispositif et un procédé de maintien d'au moins une cellule photovoltaïque.

Elle concerne également un dispositif de dépôt de couches minces et un procédé de passivation d'au moins une cellule photovoltaïque.

### ÉTAT DE LA TECHNIQUE

Un module photovoltaïque comprend une multitude de cellules photovoltaïques identiques connectées en série et/ou en parallèle afin de fournir en sortie la tension et/ou le courant requis pour alimenter des dispositifs électriques. Le format de module le plus courant emploie 60 cellules carrées (ou « pseudo-carrées »), de 156 mm de côté, réparties en six chaînes (« strings » en anglais) de dix cellules connectées en série. Les six chaînes de cellules photovoltaïques sont également connectées en série. La tension de circuit ouvert aux bornes du module est alors égale à 60 fois la tension de seuil d'une cellule photovoltaïque. Le courant électrique du module correspond approximativement au courant fourni par chaque cellule photovoltaïque (en pratique, les cellules photovoltaïques n'ont pas exactement les mêmes performances et le courant électrique est limité par la cellule la moins performante du module).

Avec les dernières technologies de cellules photovoltaïques, notamment la technologie PERT (pour « Passivated Emitter and Rear Totally diffused » en anglais), le courant d'une cellule monofaciale de 156 mm x 156 mm en superficie atteint des valeurs élevées, de l'ordre de 9 A pour une irradiance solaire de 1000 W/m². Ces valeurs de courant sont augmentées d'environ 20 % lorsqu'on utilise une cellule bifaciale, du fait du rayonnement solaire diffus capté en face arrière de la cellule. Ce fort courant électrique circule dans les éléments d'interconnexion entre les cellules du module et occasionne des pertes résistives importantes.

Afin de réduire ces pertes résistives, une solution consiste à assembler des modules avec des cellules photovoltaïques de superficie plus faible, et donc de courant plus faible. Ces cellules de plus faible superficie sont communément appelées « sous-cellules » et obtenues par découpage de cellules photovoltaïques de pleine taille (ex. 156 mm x 156 mm).

Cependant, le découpage d'une cellule photovoltaïque crée de nouveaux bords qui se retrouvent à nu. Par ailleurs, le découpage (au laser par exemple) est susceptible de créer des défauts et d'introduire des impuretés à proximité du plan de coupe. Ces défauts et impuretés diminuent la durée de vie des porteurs de charge libres en agissant comme centres de recombinaison des paires électron-trou, ce qui se traduit par une diminution du rendement de la cellule. Ce phénomène est particulièrement prononcé pour les cellules photovoltaïques à hétérojonction (HET), qui possèdent par nature très peu de défauts de surface et où la création de quelques défauts localisés suffit à réduire les performances électriques de la cellule de manière significative.

Il est notamment connu du document FR3091025 un procédé de passivation de cellules photovoltaïques permettant de localiser le dépôt d'un matériau de passivation au voisinage d'un bord seulement de la cellule photovoltaïque.

Pour être compatible avec les exigences d'une production industrielle, tout en déposant un matériau de passivation uniquement sur les bords des cellules photovoltaïques, le document FR3091025 décrit un agencement consistant à empiler une pluralité de cellules photovoltaïques les unes sur les autres, l'empilement reposant directement sur un support.

Selon cet agencement, les faces avant et arrière de chaque cellule photovoltaïque sont donc en contact direct avec l'une des faces d'une autre cellule photovoltaïque ou avec le support. Ce contact direct entraîne des risques de dégradations de ces faces avant et arrière. Or, les faces avant et/ou arrière comprennent des métallisations (ex. doigts de collecte, busbars) sur lesquelles sont soudées ou collées des éléments d'interconnexion (rubans, fils, ...).

De plus, l'empilement d'un grand nombre de cellules photovoltaïques présente également des risques de casse des cellules photovoltaïques comprises dans l'empilement, en particulier pour les cellules photovoltaïques positionnées dans une partie inférieure de l'empilement et qui subissent alors la pression exercée par l'ensemble des cellules photovoltaïques empilées au-dessus d'elles.

Par ailleurs, en pratique, l'empilement des cellules photovoltaïques directement les unes sur les autres ne permet pas de confiner le dépôt de la couche mince au bord périphérique de la cellule photovoltaïque. Une partie de la couche mince est déposée sur les faces avant et arrière de la cellule photovoltaïque.

### RÉSUMÉ DE L'INVENTION

La présente invention vise donc à améliorer la fabrication des cellules photovoltaïques en s'assurant notamment que le processus de passivation des cellules photovoltaïques ne dégrade pas les cellules photovoltaïques elles-mêmes ni leurs performances électriques.

L'invention concerne alors tout d'abord un dispositif de de maintien d'au moins une cellule photovoltaïque pour former une couche de passivation sur une partie de ladite cellule photovoltaïque, la cellule photovoltaïque comprenant une première face, une deuxième face, opposée à ladite première face, et un bord périphérique reliant la première face et la deuxième face, le dispositif de maintien comprenant :
- une première partie de support comprenant une première face de support et une deuxième face de support opposée à ladite première face de support, la première face de support étant munie d'un premier joint d'étanchéité conformé selon un pourtour de la cellule photovoltaïque,
- une deuxième partie de support comprenant une troisième face de support et une quatrième face de support opposée à ladite troisième face de support, la troisième face de support étant munie d'un deuxième joint d'étanchéité conformé selon le pourtour de la cellule photovoltaïque, et
- des moyens de compression configurés pour maintenir la cellule photovoltaïque en appui serré contre le premier joint d'étanchéité et contre le deuxième joint d'étanchéité.

Ainsi, de manière avantageuse selon l'invention, lorsque la cellule photovoltaïque est maintenue dans le dispositif de maintien, seul le bord périphérique de la cellule photovoltaïque est visible et accessible depuis l'extérieur du dispositif de maintien (dans lequel est introduite la cellule photovoltaïque). En d'autres termes, le premier joint d'étanchéité et le deuxième joint d'étanchéité isole la première face et la deuxième face de la cellule photovoltaïque, placée dans le dispositif de maintien, de l'extérieur du dispositif de maintien.

Ainsi, lors d'un dépôt d'une couche de passivation, seul le bord périphérique de la cellule photovoltaïque est exposé aux espèces de passivation, de sorte que la couche de passivation est formée uniquement sur ce bord périphérique.

Par ailleurs, grâce à la présence des joints d'étanchéité, la première face et la deuxième face de la cellule photovoltaïque ne subissent pas de contraintes au niveau des zones munies des métallisations. Leurs performances électriques sont donc conservées.

Outre les caractéristiques qui viennent d'être évoquées dans les paragraphes précédents, le dispositif de maintien selon un aspect de l'invention peut présenter une ou plusieurs caractéristiques complémentaires parmi les suivantes, considérées individuellement ou selon toutes les combinaisons techniquement possibles :
- il est prévu des moyens de positionnement de la cellule photovoltaïque entre la première partie de support et la deuxième partie de support ;
- les moyens de positionnement comprennent des éléments de guidage positionnés en bordure du premier joint d'étanchéité et/ou du deuxième joint d'étanchéité de manière à positionner le pourtour de la cellule photovoltaïque en regard du premier joint d'étanchéité et du deuxième joint d'étanchéité ;
- les moyens de positionnement comprennent au moins un bras robotisé configuré pour positionner la cellule photovoltaïque entre la première partie de support et la deuxième partie de support de sorte que le pourtour de la cellule photovoltaïque soit positionné en regard du premier joint d'étanchéité et du deuxième joint d'étanchéité ;
- la première face de support de la première partie de support comprend une rainure conformée pour fixer le premier joint d'étanchéité sur la première partie de support ;
- la troisième face de support de la deuxième partie de support comprend une rainure conformée pour fixer le deuxième joint d'étanchéité sur la deuxième partie de support ;
- les moyens de compression sont configurés pour exercer une force de pression supérieure à 2 Newtons pour maintenir la cellule photovoltaïque en appui serré contre le premier joint d'étanchéité et contre le deuxième joint d'étanchéité ;
- les moyens de compression sont configurés pour exercer une force de pression comprise entre 2 et 10 Newtons pour maintenir la cellule photovoltaïque en appui serré contre le premier joint d'étanchéité et contre le deuxième joint d'étanchéité ;
- les moyens de compression comprennent deux pistons positionnés de part et d'autre de la première partie de support et de la deuxième partie de support ;
- les moyens de compression comprennent un élément de charge positionné sur la deuxième partie de support de manière à exercer ladite force de pression ;
- le premier joint d'étanchéité et le deuxième joint d'étanchéité sont formés dans un matériau polymère souple ;
- il est également prévu :
   une troisième partie de support comprenant une cinquième face de support et une sixième face de support opposée à ladite cinquième face de support, la cinquième face de support étant munie d'un troisième joint d'étanchéité conformé selon un autre pourtour d'une autre cellule photovoltaïque, ledit autre pourtour de l'autre cellule photovoltaïque étant similaire au pourtour de la cellule photovoltaïque, ladite autre cellule photovoltaïque comprenant une autre première face, une autre deuxième face,
   opposée à ladite autre première face, et un autre bord périphérique reliant l'autre première face et l'autre deuxième face,
   la quatrième face de support de la deuxième partie de support étant munie d'un quatrième joint d'étanchéité conformé selon le pourtour de l'autre cellule photovoltaïque,
   les moyens de compression étant configurés pour maintenir l'autre cellule photovoltaïque en appui serré contre le troisième joint d'étanchéité et contre le quatrième joint d'étanchéité.

L'invention concerne également un dispositif de dépôt de couches minces (et notamment de dépôt d'au moins une couche de passivation) sur au moins une partie d'une cellule photovoltaïque comprenant :
- un dispositif de maintien tel que défini précédemment,
- au moins une cellule photovoltaïque positionnée dans le dispositif de maintien,
- une enceinte de dépôt de couches minces (et notamment de dépôt d'au moins une couche de passivation) comprenant une paroi latérale délimitant un logement d'accueil pour le dispositif de maintien dans lequel est positionnée ladite cellule photovoltaïque, et
- des moyens d'injection d'au moins une espèce de passivation permettant de former une couche de passivation sur le bord périphérique de la cellule photovoltaïque lorsque l'espèce de passivation affleure le bord périphérique de la cellule photovoltaïque.

Il est également prévu des moyens de pompage de l'espèce de passivation configurés pour permettre la circulation de l'espèce de passivation autour du dispositif de maintien selon un flux directionnel.

La présente invention concerne également un procédé de maintien d'au moins une cellule photovoltaïque comprenant une première face, une deuxième face, opposée à ladite première face, et un bord périphérique reliant la première face et la deuxième face, le procédé comprenant des étapes de :
- fourniture d'une première partie de support comprenant une première face de support et une deuxième face de support opposée à ladite première face de support, la première face de support étant munie d'un premier joint d'étanchéité conformé selon un pourtour de la cellule photovoltaïque,
- fourniture d'une deuxième partie de support comprenant une troisième face de support et une quatrième face de support opposée à ladite troisième face de support, la troisième face de support étant munie d'un deuxième joint d'étanchéité conformé selon le pourtour de la cellule photovoltaïque,
- positionnement de la cellule photovoltaïque entre la première partie de support et la deuxième partie de support, et
- compression d'un empilement formé par la première partie de support, la cellule photovoltaïque et la deuxième partie de support de manière à maintenir la cellule photovoltaïque en appui serré contre le premier joint d'étanchéité et contre le deuxième joint d'étanchéité.

Dans ce procédé de maintien, l'étape de positionnement comprend le positionnement successif de la première partie de support, de la cellule photovoltaïque et de la deuxième partie de support.

L'invention concerne enfin un procédé de passivation d'au moins une cellule photovoltaïque comprenant des étapes de :
- maintien de la cellule photovoltaïque dans un dispositif de maintien selon un procédé de maintien tel qu'introduit précédemment,
- positionnement du dispositif de maintien muni de la cellule photovoltaïque dans une enceinte de dépôt de couches minces, et
- injection d'au moins une espèce de passivation dans l'enceinte de dépôt de couches minces de manière à former une couche de passivation sur un bord périphérique de la cellule photovoltaïque lorsque l'espèce de passivation affleure le bord périphérique de la cellule photovoltaïque.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
La figure 1 est une représentation en perspective d'un dispositif de maintien selon un premier mode de réalisation de l'invention,
La figure 2 est une vue en coupe selon l'axe A-A du dispositif de maintien de la figure 1,
La figure 3 est une vue en coupe d'une variante du dispositif de maintien de la figure 1,
La figure 4 est une vue du dessus d'une partie de support comprise dans le dispositif de maintien de la figure 1,
La figure 5 représente une vue de côté d'un dispositif de maintien, dans une position de chargement, selon un deuxième mode de réalisation conforme à l'invention,
La figure 6 représente une vue de côté d'un dispositif de maintien, dans une position de compression, selon le deuxième mode de réalisation conforme à l'invention,
La figure 7 représente une vue de côté d'un dispositif de maintien, dans une position de chargement, selon un troisième mode de réalisation conforme à l'invention,
La figure 8 représente une vue de côté d'un dispositif de maintien, dans une position de compression, selon un troisième mode de réalisation conforme à l'invention,
La figure 9 représente une vue de côté d'un dispositif de maintien, dans une position de chargement, selon un quatrième mode de réalisation conforme à l'invention,
La figure 10 représente une vue de côté d'un dispositif de maintien, dans une position de compression, selon un quatrième mode de réalisation conforme à l'invention,
La figure 11 est une vue du dessus d'une partie de support comprise dans le dispositif de maintien de la figure 9, et
La figure 12 représente un exemple du dispositif de dépôt de couches minces conforme à la présente invention.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

La présente invention vise à améliorer la fabrication des cellules photovoltaïques et en particulier à améliorer la phase de passivation des cellules photovoltaïques. Plus particulièrement, la présente invention vise, dans un premier temps, à améliorer le maintien des cellules photovoltaïques lors de la phase de passivation.

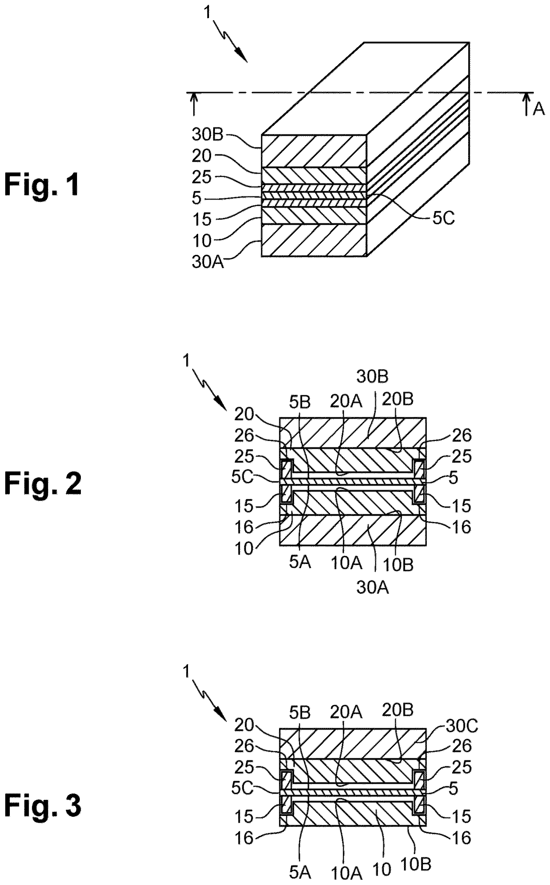

Pour cela, l'invention propose, comme le montrent les figures 1 à 11, un dispositif de maintien 1 ; 100 ; 150 ; 200 d'au moins une cellule photovoltaïque 5. Ce dispositif de maintien 1 ; 100 ; 150 ; 200 correspond en fait ici à une nacelle permettant le chargement d'au moins une cellule photovoltaïque 5. Le terme « *nacelle* » signifie ici un support recevant la cellule photovoltaïque 5 à la surface de laquelle va être réalisé un dépôt en couche mince d'une couche de passivation.

Il est à noter ici que la cellule photovoltaïque 5 ne fait pas partie du dispositif de maintien 1 ; 100 ; 150 ; 200 en lui-même. Cependant, pour la clarté de l'exposé, le dispositif de maintien 1 ; 100 ; 150 ; 200 est décrit en relation avec cette cellule photovoltaïque 5.

Les cellules photovoltaïques 5 concernées par la présente invention sont par exemple des sous-cellules, c'est-à-dire des portions ou morceaux d'une cellule photovoltaïque de pleine taille (aussi qualifiée de cellule photovoltaïque « entière »).

Les sous-cellules sont par exemple préalablement obtenues par découpage de cellules photovoltaïques de pleine taille.

Les cellules photovoltaïques de pleine taille ont été préalablement fabriquées à partir de substrats semi-conducteurs, par exemple en silicium cristallin. Ces substrats ont été initialement découpés dans un lingot de silicium, puis ont été soumis à plusieurs étapes de fabrication (par exemple des étapes de structuration de surface, dopage, recuit, passivation, sérigraphie...), mais aucune autre étape de découpage. Les cellules photovoltaïques de pleine taille présentent des couches de passivation sur l'ensemble de ses faces et surfaces latérales.

Les cellules photovoltaïques 5 concernées par la présente invention comprennent chacune une première face 5A et une deuxième face 5B, opposée à la première face 5A. La première face 5A est par exemple celle destinée à être exposée au rayonnement solaire incident.

Chaque cellule photovoltaïque 5 comprend également un bord périphérique 5C reliant la première face 5A et la deuxième face 5B. Ce bord périphérique 5C correspond donc à la surface latérale liant la première face 5A et la deuxième face 5B. Par définition ici, le bord périphérique 5C s'étend donc sur l'ensemble du pourtour de la première face 5A et de la deuxième face 5B de la cellule photovoltaïque 5. Dans la présente description, on entend par « pourtour » de la cellule photovoltaïque 5, la ligne de contour de la première face 5A et/ou de la deuxième face 5B.

Vues de face (depuis la première face 5A ou la deuxième face 5B), les cellules photovoltaïques 5 présentent de préférence une forme rectangulaire ou pseudo-rectangulaire. Dans le format pseudo-rectangulaire, les quatre coins des cellules photovoltaïques 5 sont tronqués ou arrondis. En particulier, les cellules photovoltaïques 5 peuvent présenter une forme carrée ou pseudo-carrée.

Le pourtour de la cellule photovoltaïque 5 présente donc ici une forme rectangulaire ou pseudo-rectangulaire (ou, dans le cas particulier, carrée ou pseudo-carrée).

Les dimensions de la première face 5A et de la deuxième face 5B sont généralement standardisées, par exemple 156 mm x 156 mm.

Les cellules photovoltaïques 5 peuvent être des cellules monofaciales ou bifaciales. Dans le cas d'une cellule monofaciale, seule la première face 5A de la cellule photovoltaïque 5 capte le rayonnement solaire. Dans le cas d'une cellule bifaciale, les deux faces 5A, 5B de la cellule photovoltaïque 5 captent le rayonnement solaire. La première face 5A est alors celle permettant d'obtenir le maximum de courant électrique lorsqu'elle est tournée vers le soleil.

De préférence, les cellules photovoltaïques 5 sont prêtes à être interconnectées en une chaîne de cellules. Elles sont munies sur la première face 5A et/ou sur la deuxième face 5B d'une ou plusieurs métallisations (non représentées) destinées à collecter les porteurs de charge photogénérés et à recevoir des éléments d'interconnexion, par exemple des fils ou rubans métalliques. Les métallisations sont de préférence des pistes électriquement conductrices appelées « busbars ». Les busbars peuvent relier électriquement des doigts de collecte répartis sur toute la superficie de la première face 5A et/ou de la deuxième face 5B. La deuxième face 5B des cellules photovoltaïques 5 peut aussi être entièrement métallisée. Dans une variante de mise en oeuvre, les cellules photovoltaïques 5 sont dépourvues de busbars 5 mais comportent uniquement des doigts de collecte.

Comme les cellules photovoltaïques 5 sont obtenues par découpage d'une cellule photovoltaïque de pleine taille dont les faces sont munies de couches de passivation, la première face 5A et la deuxième face 5B de chaque cellule photovoltaïque 5 présente une couche de passivation. Cette couche de passivation rend inactifs les défauts de surface de la cellule photovoltaïque 100 et améliore la durée de vie des porteurs de charge photogénérés.

En revanche, le bord périphérique 5C de la cellule photovoltaïque comprend des zones où le matériau semi-conducteur (i.e. le silicium) a été mis à nu. Autrement dit, ces zones du bord périphérique 5C sont dépourvues de couche de passivation (à cause du découpage), à la différence de la première face 5A, de la deuxième face 5B et des (éventuelles) autres zones du bord périphérique 5C de la cellule photovoltaïque 5. Par exemple, lorsqu'une cellule photovoltaïque de pleine taille est découpée en quatre bandes de cellule parallèles, deux bandes de cellule présentent deux bords parallèles non passivés, et deux autres bandes de cellule présentent un seul bord non passivé.

La présente invention vise donc à protéger, par formation d'une couche de passivation, ces zones dans lesquelles le matériau semi-conducteur est mis à nu, sans que ce dépôt n'atteigne la première face 5A et la deuxième face 5B (car cela risquerait de dégrader les performances électriques de la cellule photovoltaïque 5).

Pour cela, la présente invention concerne tout d'abord le dispositif de maintien 1 ; 100 ; 150 ; 200 de la cellule photovoltaïque 5 en vue de la formation d'une couche de passivation sur une partie de cette cellule photovoltaïque 5.

Les figures 1 à 11 représentent différents modes de réalisation du dispositif de maintien selon la présente invention.

Les figures 1 à 4 représentent un premier mode de réalisation du dispositif de maintien 1. Comme visible sur ces figures, le dispositif de maintien 1 comprend une première partie de support 10, une deuxième partie de support 20 et des moyens de compression 30A, 30B ; 30C.

La première partie de support 10 comprend une première face de support 10A et une deuxième face de support 10B opposée à la première face de support 10A. Elle est formée dans un matériau dit plein, c'est-à-dire qui ne comporte pas de portions vides. Cela permet notamment de renforcer la résistance de la première partie de support 10, en particulier lors de la compression mise en oeuvre par les moyens de compression 30A, 30B, 30C (comme cela sera décrit par la suite). Le matériau plein est par exemple ici un matériau de type acier inoxydable ou aluminium anodisé. Ce matériau utilisé est particulièrement adapté à la mise en oeuvre de la passivation de cellules photovoltaïques car il ne sera pas détérioré lors de cette mise en oeuvre.

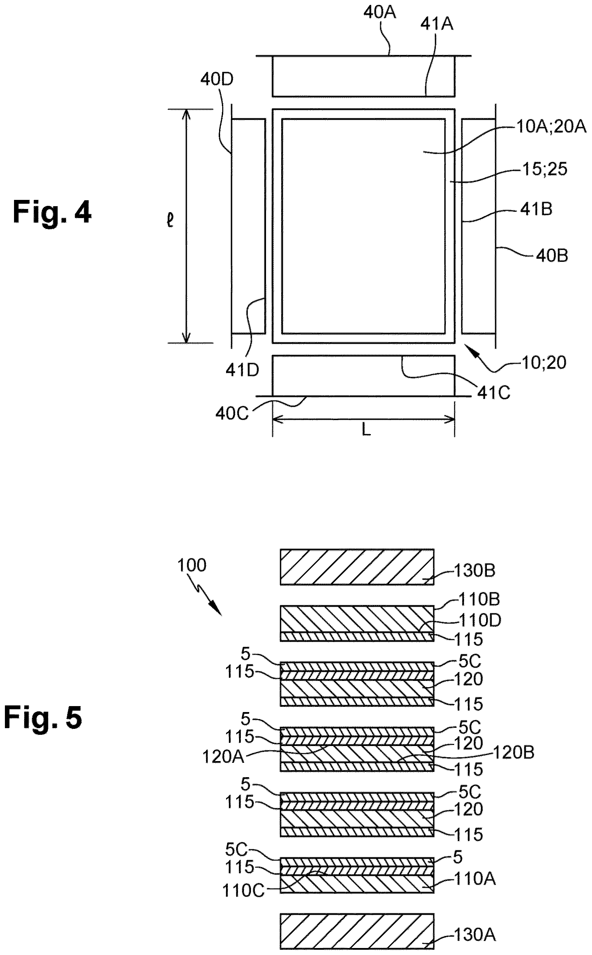

Comme cela est visible sur les figures 1 et 4, la première partie de support 10 présente de préférence une forme globalement parallélépipédique. En variante, elle pourrait présenter une forme différente, tant que la forme concernée présente deux faces opposées sensiblement parallèles (peu importe leur forme).

La première partie de support 10 comporte ici une longueur l et une largeur L (figure 4), correspondant à des dimensions caractéristiques de la section rectangulaire de la première partie de support 10 (de forme parallélépipédique). La longueur l et la largeur L sont ici déterminées en fonction des dimensions de la cellule photovoltaïque 5.

De manière préférentielle, la longueur l et la largeur L de la première partie de support 10 sont semblables à la longueur et la largeur de la cellule photovoltaïque 5. Par « semblable » (ou « similaire »), on entend dans cette description que la différence entre les deux grandeurs considérées est inférieure à 10%.

La longueur l est par exemple supérieure à 30 millimètres (mm). De préférence, elle est comprise entre 50 et 210 mm.

La largeur L est par exemple supérieure à 20 mm. De préférence, elle est comprise entre 25 et 210 mm.

Comme cela est représenté sur les figures 1 à 4, la première face de support 10A est munie d'un premier joint d'étanchéité 15. Ce premier joint d'étanchéité 15 est configuré pour venir en appui contre la première face 5A de la cellule photovoltaïque 5.

Le premier joint d'étanchéité 15 présente ici une section transversale rectangulaire (figures 2 et 3). En variante, sa section transversale peut par exemple être cylindrique.

De manière avantageuse ici, le premier joint d'étanchéité 15 est conformé selon le pourtour de la cellule photovoltaïque 5. Autrement dit, le premier joint d'étanchéité 15 se présente sous la forme d'un cordon présentant la forme de la circonférence (c'est-à-dire de la limite extérieure) de la cellule photovoltaïque 5.

Ici, sachant que la cellule photovoltaïque 5 présente une forme rectangulaire, le premier joint d'étanchéité 15 s'étend donc selon une forme rectangulaire correspondant à la périphérie de la cellule photovoltaïque 5 (comme cela est visible sur la figure 4).

En pratique, le premier joint d'étanchéité 15 est formé dans un matériau polymère souple. Un tel matériau polymère souple est par exemple défini à partir de l'échelle de dureté standard Shore A. Dans le cadre de l'invention, les matériaux considérés présentent par exemple un indice compris entre 70 et 90 sur cette échelle Shore A. Il s'agit ici par exemple de fluoroélastomères.

En particulier, le matériau polymère souple utilisé pour le premier joint d'étanchéité 15 est ici adapté pour supporter des températures de passivation comprises entre 50 et 200 degrés Celsius (°C).

Il s'agit par exemple de matériaux tels que des élastomères fluorés (de type FKM) ou d'un mélange de caoutchouc synthétique, d'élastomère et d'un matériau polymère fluoré.

Ces matériaux sont particulièrement avantageux pour former le premier joint d'étanchéité car ils présentent des qualités de résistance à des températures élevées (jusqu'à 200°C typiquement) et de résistance aux gaz comme par exemple à l'ozone et à l'oxygène ou à un plasma.

Par ailleurs, ces matériaux présentent une faible perméabilité aux gaz, et notamment aux gaz utilisés pour la passivation de la cellule photovoltaïque décrite ci-après.

En d'autres termes, les matériaux utilisés pour former le premier joint d'étanchéité 15 sont particulièrement adaptés à la mise en oeuvre de la passivation de cellules photovoltaïques car ils ne seront pas détériorés lors de cette mise en oeuvre. Grâce aux propriétés du matériau utilisé pour le former, les qualités d'étanchéité du premier joint d'étanchéité 15 sont conservées pour les applications visées dans la présente invention (et en particulier pour le dépôt de couches de passivation).

Le premier joint d'étanchéité 15 est par exemple un joint d'étanchéité statique en fluoroélastomères de la marque Viton^{™}.

Le premier joint d'étanchéité 15 est fixé sur la première face de support 10A de la première partie de support 10. Quel que soit le moyen de fixation utilisé, le premier joint d'étanchéité 15 est fixé à la première partie de support 10 de manière à être localisé en regard de la périphérie de la cellule photovoltaïque 5. Plus particulièrement, le premier joint d'étanchéité 15 est fixé à la première partie de support 10 de manière à être localisé en regard de la bordure d'extrémité de la première face 5A de la cellule photovoltaïque 5.

De manière avantageuse, la première face de support 10A de la première partie de support 10 comprend une rainure 16 conformée pour permettre la fixation du premier joint d'étanchéité 15 dans la première partie de support 10.

Comme cela est visible sur les figures 2 et 3, la rainure 16 est « creusée », dans la première partie de support 10, depuis la première face de support 10A de la première partie de support 10.

Ici, la rainure 16 s'étend en bordure de la première partie de support 10, sur l'ensemble de la périphérie de la première face de support 10A. Cela permet alors de positionner (et fixer) le premier joint d'étanchéité 15 en regard de la périphérie de la première face 5A de la cellule photovoltaïque 5.

De manière à permettre la fixation du premier joint d'étanchéité 15 à la première partie de support 10, la rainure 16 présente par exemple une section (dans le plan de la première face de support 10A) plus faible au niveau de son ouverture (donc au niveau de la première face de support 10A) qu'au niveau de sa paroi de fond (dans un plan parallèle au plan de la première face de support 10A).

Le premier joint d'étanchéité 15 est introduit dans la rainure 16 ainsi conformée en exerçant une force de pression (c'est-à-dire en le comprimant). L'ouverture de la rainure, de section plus faible, permet alors de maintenir le premier joint d'étanchéité 15 dans la rainure 16, et donc de le fixer à la première partie de support 10.

En variante, la rainure 16 peut présenter une section transversale (c'est-à-dire dans un plan orthogonal à la première face de support 10A) plus faible que la section transversale du premier joint d'étanchéité 15.

Le premier joint d'étanchéité 15 est introduit dans la rainure 16 conformée selon cette variante en exerçant une force de pression (c'est-à-dire en le comprimant). Un fois introduit dans cette rainure 16, le premier joint d'étanchéité 15 se détend. Cette détente entraîne alors une force de pression exercée, par le premier joint d'étanchéité 15, sur les parois de la rainure 16. Cela maintient alors le premier joint d'étanchéité 15 dans la rainure 16 (et permet donc de le fixer à la première partie de support 10).

De manière alternative à la rainure décrite, le premier joint d'étanchéité peut être fixé par collage à la première face de support 10A de la première partie de support 10. La colle utilisée pour le collage présente notamment des propriétés de résistance à des températures élevées (jusqu'à 200°C typiquement). La colle présente également une faible perméabilité aux gaz, et notamment aux gaz utilisés pour la passivation de la cellule photovoltaïque décrite ci-après. Une colle à base de fluoroélastomère peut par exemple être utilisée dans cette alternative.

Comme cela est représenté sur les figures 1 à 4, le dispositif de maintien 1 comprend également la deuxième partie de support 20. Cette deuxième partie de support 20 présente des caractéristiques similaires à celles de la première partie de support 10 détaillées précédemment. La deuxième partie de support 20 peut être vue, dans ce premier mode de réalisation de l'invention, comme le symétrique de la première partie de support 10 par rapport à un plan dans lequel sera positionnée la cellule photovoltaïque 5. Ces caractéristiques sont présentées, dans la suite, dans le contexte de la deuxième partie de support 20.

La deuxième partie de support 20 comprend une troisième face de support 20A et une quatrième face de support 20B opposée à la troisième face de support 20A. Elle est formée dans un matériau dit plein, c'est-à-dire qui ne comporte pas de portions vides. Cela permet notamment de renforcer la résistance de la deuxième partie de support 20, en particulier lors de la compression mise en oeuvre par les moyens de compression (comme cela sera décrit par la suite). Le matériau plein est par exemple ici un matériau de type acier inoxydable ou aluminium anodisé. Ce matériau utilisé est particulièrement adapté à la mise en oeuvre de la passivation de cellules photovoltaïques car il ne sera pas détérioré lors de cette mise en oeuvre.

Comme cela est visible sur les figures 1 et 4, la deuxième partie de support 20 présente de préférence une forme globalement parallélépipédique. En variante, elle pourrait présenter une forme différente, tant que la forme concernée présente deux faces opposées sensiblement parallèles (peu importe leur forme).

La deuxième partie de support 20 comporte ici une longueur l et une largeur L (figure 4), correspondant à des dimensions caractéristiques de la section rectangulaire de la deuxième partie de support 20 (de forme parallélépipédique). La longueur l et la largeur L sont ici déterminées en fonction des dimensions de la cellule photovoltaïque 5.

De manière préférentielle, la longueur l et la largeur L de la deuxième partie de support 10 sont semblables à la longueur et la largeur de la cellule photovoltaïque 5.

La longueur l est par exemple supérieure à 30 millimètres (mm). De préférence, elle est comprise entre 50 et 210 mm.

La largeur L est par exemple supérieure à 20 mm. De préférence, elle est comprise entre 25 et 210 mm.

Comme cela est représenté sur les figures 1 à 4, la troisième face de support 20A est munie d'un deuxième joint d'étanchéité 25. Ce deuxième joint d'étanchéité 25 est configuré pour venir en appui contre la deuxième face 5B de la cellule photovoltaïque 5.

Le deuxième joint d'étanchéité 25 présente ici une section transversale rectangulaire (figures 2 et 3). En variante, sa section transversale peut par exemple être cylindrique.

De manière avantageuse ici, le deuxième joint d'étanchéité 25 est conformé selon le pourtour de la cellule photovoltaïque 5. Autrement dit, le deuxième joint d'étanchéité 25 se présente sous la forme d'un cordon présentant la forme de la circonférence (c'est-à-dire de la limite extérieure) de la cellule photovoltaïque 5.

Ici, sachant que la cellule photovoltaïque 5 présente une forme rectangulaire, le deuxième joint d'étanchéité 25 s'étend donc selon une forme rectangulaire correspondant à la périphérie de la cellule photovoltaïque 5 (comme cela est visible sur la figure 4).

En pratique, le deuxième joint d'étanchéité 25 est formé dans un matériau polymère souple. Un tel matériau polymère souple est par exemple défini à partir de l'échelle de dureté standard Shore A. Dans le cadre de l'invention, les matériaux considérés présentent par exemple un indice compris entre 70 et 90 sur cette échelle Shore A. Il s'agit ici par exemple de fluoroélastomères.

En particulier, le matériau polymère souple utilisé pour le deuxième joint d'étanchéité 25 est ici adapté pour supporter des températures de passivation comprises entre 50 et 200 degrés Celsius (°C).

Il s'agit par exemple de matériaux tels que des élastomères fluorés (de type FKM) ou d'un mélange de caoutchouc synthétique, d'élastomère et d'un matériau polymère fluoré.

Ces matériaux sont particulièrement avantageux pour former le deuxième joint d'étanchéité car ils présentent des qualités de résistance à des températures élevées (jusqu'à 200°C typiquement) et de résistance aux gaz comme par exemple à l'ozone et à l'oxygène ou à un plasma.

Par ailleurs, ces matériaux présentent une faible perméabilité aux gaz, et notamment aux gaz utilisés pour la passivation de la cellule photovoltaïque décrite ci-après.

En d'autres termes, les matériaux utilisés pour former le deuxième joint d'étanchéité 25 sont particulièrement adaptés à la mise en oeuvre de la passivation de cellules photovoltaïques car ils ne seront pas détériorés lors de cette mise en oeuvre. Grâce aux propriétés du matériau utilisé pour le former, les qualités d'étanchéité du deuxième joint d'étanchéité 25 sont conservées pour les applications visées dans la présente invention (et en particulier pour le dépôt de couches de passivation).

Le deuxième joint d'étanchéité 25 est par exemple un joint d'étanchéité statique en fluoroélastomères de la marque Viton^{™}.

Le deuxième joint d'étanchéité 25 est fixé sur la troisième face de support 20A de la deuxième partie de support 20. Quel que soit le moyen de fixation utilisé, le deuxième joint d'étanchéité 25 est fixé à la deuxième partie de support 20 de manière à être localisé en regard de la périphérie de la cellule photovoltaïque 5. Plus particulièrement, le deuxième joint d'étanchéité 25 est fixé à la deuxième partie de support 20 de manière à être localisé en regard de la bordure d'extrémité de la deuxième face 5B de la cellule photovoltaïque 5.

Ainsi, le deuxième joint d'étanchéité 25 est positionné, sur la troisième face de support 20A de la deuxième partie de support 20, en regard du premier joint d'étanchéité 15 fixé sur la première partie de support 10. Cela est particulièrement avantageux lors du maintien de la cellule photovoltaïque 5 entre la première partie de support 10 et la deuxième partie de support 20 car ce positionnement en regard du premier joint d'étanchéité 15 et du deuxième joint d'étanchéité 25 entraîne un appui symétrique sur la cellule photovoltaïque 5 (sur la première face 5A et la deuxième face 5B). Cela permet d'éviter un éventuel déséquilibre dans les forces de pression appliquées sur les deux faces de la cellule photovoltaïque 5, et donc d'éviter un risque de dégradation, voire même de casse de la cellule photovoltaïque 5 lors de son maintien dans le dispositif de maintien 1 (pour un dépôt de couche de passivation par exemple).

De manière avantageuse, la troisième face de support 20 A de la deuxième partie de support 20 comprend une rainure 26 conformée pour permettre la fixation du deuxième joint d'étanchéité 25 dans la deuxième partie de support 20.

Comme cela est visible sur les figures 2 et 3, la rainure 26 est « creusée », dans la deuxième partie de support 20, depuis la troisième face de support 20A de la deuxième partie de support 20.

Ici, la rainure 26 s'étend en bordure de la deuxième partie de support 20, sur l'ensemble de la périphérie de la troisième face de support 20A. Cela permet alors de positionner (et fixer) le deuxième joint d'étanchéité 25 en regard de la périphérie de la deuxième face 5B de la cellule photovoltaïque 5.

De manière à permettre la fixation du deuxième joint d'étanchéité 25 à la deuxième partie de support 20, la rainure 26 présente par exemple une section (dans le plan de la troisième face de support 20A) plus faible au niveau de son ouverture (donc au niveau de la troisième face de support 20A) qu'au niveau de sa paroi de fond (dans un plan parallèle au plan de la troisième face de support 20A).

Le deuxième joint d'étanchéité 25 est introduit dans la rainure 26 ainsi conformée en exerçant une force de pression (c'est-à-dire en le comprimant). L'ouverture de la rainure, de section plus faible, permet alors de maintenir le deuxième joint d'étanchéité 25 dans la rainure 26, et donc de le fixer à la deuxième partie de support 20.

En variante, la rainure 26 peut présenter une section transversale (c'est-à-dire dans un plan orthogonal à la troisième face de support 20A) plus faible que la section transversale du deuxième joint d'étanchéité 25.

Le deuxième joint d'étanchéité 25 est introduit dans la rainure 26 conformée selon cette variante en exerçant une force de pression (c'est-à-dire en le comprimant). Un fois introduit dans cette rainure 26, le deuxième joint d'étanchéité 25 se détend. Cette détente entraîne alors une force de pression exercée par le deuxième joint d'étanchéité 25 sur les parois de la rainure 26. Cela maintient alors le deuxième joint d'étanchéité 25 dans la rainure 26 (et permet donc de le fixer à la troisième partie de support 20).

De manière alternative à la rainure décrite, le deuxième joint d'étanchéité 25 peut être fixé par collage à la troisième face de support 20A de la deuxième partie de support 20. La colle utilisée pour le collage présente notamment des propriétés de résistance à des températures élevées (jusqu'à 200°C typiquement). La colle présente également une faible perméabilité aux gaz, et notamment aux gaz utilisés pour la passivation de la cellule photovoltaïque décrite ci-après. Une colle à base de fluoroélastomère peut par exemple être utilisée dans cette alternative.

Ainsi, la première partie de support 10 et la deuxième partie de support 20 sont agencées de manière à « prendre en sandwich » la cellule photovoltaïque 5 pour la maintenir dans le dispositif de maintien 1. Plus particulièrement, comme cela est visible sur les figures 1 à 3, la cellule photovoltaïque 5 est positionnée entre le premier joint d'étanchéité 15 et le deuxième joint d'étanchéité 25.

De manière avantageuse, comme décrit précédemment, le premier joint d'étanchéité 15 et le deuxième joint d'étanchéité 25 sont positionnés en regard l'un de l'autre de manière à venir en appui de manière symétrique, respectivement, sur la première face 5A et la deuxième face 5B de la cellule photovoltaïque 5.

Afin que la cellule photovoltaïque 5 soit maintenue dans le dispositif de maintien 1 à une position particulière (notamment pour le dépôt d'une couche de passivation décrit ci-après), le dispositif de maintien 1 comprend les moyens de compression 30A, 30B ; 30C.

Ces moyens de compression 30A, 30B ; 30C sont configurés pour maintenir la cellule photovoltaïque 5 en appui serré contre le premier joint d'étanchéité 15 et le deuxième joint d'étanchéité 25.

Dans cette description, on entend par « appui serré », un maintien étroit de la cellule photovoltaïque 5 entre le premier joint d'étanchéité 15 et le deuxième joint d'étanchéité 25, en exerçant une certaine force de pression sur celle-ci.

En d'autres termes, les moyens de compression 30A, 30B ; 30C permettent de maintenir fermement la cellule photovoltaïque 5 entre le premier joint d'étanchéité et le deuxième joint d'étanchéité 25 (donc entre la première partie de support 10 et la deuxième partie de support 20) de sorte que la position de la cellule photovoltaïque 5 ainsi maintenue ne peut pas être modifiée.

Compte-tenu de la forme et du positionnement du premier joint d'étanchéité 15 et du deuxième joint d'étanchéité 25, l'appui serré est mis en oeuvre au niveau de la périphérie de la première face 5A et de la deuxième face 5B de la cellule photovoltaïque 5, de manière symétrique sur la première face 5A et la deuxième face 5B.

En d'autres termes, cet appui serré est réalisé au niveau des parties des faces de la cellule photovoltaïque 5 qui ne comprennent pas de métallisations ou d'éléments fragiles. La localisation de cet appui serré permet donc d'éviter la dégradation de la cellule photovoltaïque 5 et de ses performances électriques.

De plus, cet agencement permet d'exercer une force de pression de maintien au même niveau sur la première face 5A et la deuxième face 5B de la cellule photovoltaïque 5, de sorte qu'il n'y a pas de déséquilibre entre les forces exercées sur les deux faces de la cellule photovoltaïque 5. Cela permet alors d'éviter des risques de casse de la cellule photovoltaïque 5.

Comme cela est visible sur les figures 1 à 3, lorsque la cellule photovoltaïque 5 est maintenue dans le dispositif de maintien 1, seul le bord périphérique 5C de la cellule photovoltaïque 5 est visible et accessible depuis l'extérieur du dispositif de maintien 1 (dans lequel est introduit la cellule photovoltaïque 5). En d'autres termes, le premier joint d'étanchéité 15 et le deuxième joint d'étanchéité 25 isole la première face 5A et la deuxième face 5B de la cellule photovoltaïque 5, placée dans le dispositif de maintien 1, de l'extérieur du dispositif de maintien 1 (et en particulier, comme cela sera décrit par la suite, de l'espèce de passivation utilisée pour le dépôt d'une couche de passivation).

En pratique, les moyens de compression 30A, 30B ; 30C sont configurés pour exercer une force de pression supérieure à 2 Newtons (N).

De préférence selon l'invention, les moyens de compression 30A, 30B ; 30C sont configurés pour exercer une force de pression comprise entre 2 et 10 N. De manière avantageuse, cette force de pression est suffisante pour maintenir la cellule photovoltaïque 5 en position, sans que la cellule photovoltaïque 5 ne puisse bouger entre le premier joint d'étanchéité 15 et le deuxième joint d'étanchéité 25 (et donc entre la première partie de support 10 et la deuxième partie de support 20). Par ailleurs, la force de pression exercée par les moyens de compression 30A, 30B ; 30C n'est pas trop importante pour éviter les risques de casse de la cellule photovoltaïque 5 (lorsque celle-ci est maintenue en appui serré entre le premier joint d'étanchéité 15 et le deuxième joint d'étanchéité 25).

En pratique, deux positions du dispositif de maintien 1 peuvent être identifiées en fonction de l'état des moyens de compression 30A, 30B ; 30C. Lorsque les moyens de compression 30A, 30B ; 30C sont dans un état de repos (ils n'exercent donc pas de force de compression), le dispositif de maintien est dans une position dite « position de chargement » dans laquelle la cellule photovoltaïque 5 peut être positionnée dans entre la première partie de support 10 et la deuxième partie de support 20. Le dispositif de maintien 1 est, en quelque sorte, « ouvert ». En d'autres termes, dans cette position de chargement, le premier joint d'étanchéité 15 et le deuxième joint d'étanchéité 25 sont à distance l'un de l'autre, c'est-à-dire qu'un espace est défini entre les deux.

Dans ce premier mode de réalisation, l'écart entre la première partie de support 10 et la deuxième partie de support 20, dans la position de chargement du dispositif de maintien 1, n'est pas déterminant.

Lorsque les moyens de compression 30A, 30B ; 30C exercent la force de pression correspondante pour maintenir la cellule photovoltaïque 5 entre le premier joint d'étanchéité 15 et le deuxième joint d'étanchéité 25, le dispositif de maintien 1 est dans une position dite « position de compression ». Les figures 1 à 3 illustrent le dispositif de maintien 1 dans cette position de compression. La position de chargement n'est pas représentée pour ce premier mode de réalisation (mais l'est sur les figures 5, 7 et 9 pour les autres modes de réalisation du dispositif de maintien 100 ; 150 ; 200 décrits ci-après).

En d'autres termes, les moyens de compression 30A, 30B ; 30C sont configurés pour comprimer la première partie de support 10 et la deuxième partie de support 20 depuis une position de chargement (permettant l'introduction de la cellule photovoltaïque 5 dans le dispositif de maintien 1) vers une position de compression (dans laquelle la cellule photovoltaïque 5 est maintenue en appui serré entre le premier joint d'étanchéité 15 et le deuxième joint d'étanchéité 25).

Selon une première alternative représentée sur la figure 2, les moyens de compression 30A, 30B comprennent deux pistons 30A, 30B positionnés de part et d'autre de la première partie de support 10 et de la deuxième partie de support 20.

Plus particulièrement, le premier piston 30A est positionné en contact de la deuxième face de support 10B de la première partie de support 10. Le premier piston 30A exerce alors une force de pression dirigée vers la cellule photovoltaïque 5 de manière que le premier joint d'étanchéité 15 soit en appui serré contre la première face 5A de la cellule photovoltaïque 5.

Le deuxième piston 30B est quant à lui positionné en contact de la quatrième face 20B de la deuxième partie de support 20. Le deuxième piston 30B exerce alors une force de pression dirigée vers la cellule photovoltaïque 5 de manière à ce que le deuxième joint d'étanchéité 25 soit en appui serré contre la deuxième face 5B de la cellule photovoltaïque 5. Les forces de pression exercées par les deux pistons 30A, 30B sont opposées et semblables en norme de manière à permettre le maintien de la cellule photovoltaïque 5 entre le premier joint d'étanchéité 15 et le deuxième joint d'étanchéité 25.

Selon une deuxième alternative représentée sur la figure 3, les moyens de compression 30C comprennent un élément de charge 30C positionné sur la deuxième partie de support 20. Cet élément de charge 30C est par exemple une masse positionnée sur la quatrième face de support 20B de la deuxième partie de support 20 et dont le poids correspond à la force de pression exercée pour maintenir la cellule photovoltaïque 5 entre le premier joint d'étanchéité 15 et le deuxième joint d'étanchéité 25.

En variante, cet élément de charge est par exemple formé par l'empilement d'une pluralité de parties de support (dont le poids correspond à la force de pression exercée pour maintenir la cellule photovoltaïque 5 entre le premier joint d'étanchéité 15 et le deuxième joint d'étanchéité 25).

Afin d'affiner le positionnement de la cellule photovoltaïque 5 entre la première partie de support 10 et la deuxième partie de support 20 (plus particulièrement entre le premier joint d'étanchéité 15 et le deuxième joint d'étanchéité 25), de manière à s'assurer que ce positionnement soit précis, le dispositif de maintien 1 comprend également des moyens de positionnement 40A, 40B, 40C, 40D de la cellule photovoltaïque 5 entre la première partie de support 10 et la deuxième partie de support 20. Ces moyens de positionnement 40A, 40B, 40C, 40D sont configurés pour positionner la cellule photovoltaïque 5 entre le premier joint d'étanchéité 15 et le deuxième joint d'étanchéité 25 de manière à ce que le pourtour de la cellule photovoltaïque 5 soit en regard du premier joint d'étanchéité 15 et du deuxième joint d'étanchéité 25.

En d'autres termes, les moyens de positionnement 40A, 40B, 40C, 40D permettent le positionnement de la cellule photovoltaïque 5, dans le dispositif de maintien 1, entre la première partie de support 10 et la deuxième partie de support 20 afin d'aligner le pourtour de la cellule photovoltaïque 5 avec le premier joint d'étanchéité 15 et le deuxième joint d'étanchéité 25. Autrement dit encore, le bord périphérique 5C de la cellule photovoltaïque 5 s'étend dans le prolongement du premier joint d'étanchéité 15 et du deuxième joint d'étanchéité 25.

Selon une première variante de réalisation représentée sur la figure 4, les moyens de positionnement 40A, 40B, 40C, 40D sont formés par des éléments de guidage 40A, 40B, 40C, 40D. Il est ici prévu quatre éléments de guidage 40A, 40B, 40C, 40D, chaque élément de guidage 40A, 40B, 40C, 40D étant associé à l'un des côtés de la forme rectangulaire selon laquelle s'étend le contour du premier joint périphérique 15 (ou du deuxième joint périphérique 25).

Chaque élément de guidage 40A, 40B, 40C, 40D comprend alors un bord d'extrémité 41A, 41B, 41C, 41D destiné à former une butée pour l'un des côtés du bord périphérique 5C de la cellule photovoltaïque 5.

En pratique, chaque élément de guidage 40A, 40B, 40C, 40D est positionné de telle manière que le bord d'extrémité 41A, 41B, 41C, 41D correspondant soit positionné en bordure du premier joint d'étanchéité 15. Autrement dit, chaque bord d'extrémité 41A, 41B, 41C, 41D est positionné le long du pourtour du premier joint d'étanchéité 15. Ils délimitent alors un cadre de réception de la cellule photovoltaïque 5 entre la première partie de support 10 et la deuxième partie de support 20. Le cadre de réception ainsi délimité correspond au positionnement précis recherché pour la cellule photovoltaïque 5 pour permettre l'alignement du pourtour de la cellule photovoltaïque 5 avec le premier joint d'étanchéité 15 et le deuxième joint d'étanchéité 25.

De manière alternative, les éléments de guidage pourraient être formés d'une seule pièce définissant le cadre de réception mentionné ci-dessus.

Cette première variante de réalisation correspond à un dispositif de maintien 1 à chargement manuel.

Selon une deuxième variante de réalisation (non représentée), les moyens de positionnement comprennent un bras robotisé configuré pour positionner précisément la cellule photovoltaïque 5 entre la première partie de support 10 et la deuxième partie de support 20. Plus particulièrement, le bras robotisé est configuré pour positionner la cellule photovoltaïque 5 entre le premier joint d'étanchéité 15 et le deuxième joint d'étanchéité 25 afin d'aligner le pourtour de la cellule photovoltaïque 5 avec le premier joint d'étanchéité 15 et le deuxième joint d'étanchéité 25. Le bras robotisé est donc commandé pour positionner la cellule photovoltaïque 5 de telle manière que le bord périphérique 5C de la cellule photovoltaïque 5 s'étende dans le prolongement du premier joint d'étanchéité 15 et du deuxième joint d'étanchéité 25.

De manière classique, le bras robotisé est connecté à un contrôleur et au moins un capteur (non représentés). Le contrôleur permet de commander le bras robotisé afin que la cellule photovoltaïque 5 soit positionnée précisément entre le premier joint d'étanchéité 15 et le deuxième joint d'étanchéité 25 (et donc entre la première partie de support 10 et la deuxième partie de support 20). Pour cela, le contrôleur mémorise par exemple la position de la première partie de support 10 et de la deuxième partie de support 20 et commande le bras robotisé de manière à positionner la cellule photovoltaïque 5 de telle manière que le pourtour de la cellule photovoltaïque 5 s'étende dans l'alignement du premier joint d'étanchéité 15 et du deuxième joint d'étanchéité 25. Le (ou les) capteur(s) associé(s) permet(tent) d'acquérir des informations sur le positionnement, d'affiner et de vérifier qu'il a été effectué selon la commande.

L'utilisation du bras robotisé correspond à une variante avec chargement automatisé du dispositif de maintien 1 conforme à l'invention.

De manière avantageuse, le dispositif de maintien 1 selon l'invention permet de s'assurer que seul le bord périphérique 5C de la cellule photovoltaïque 5 est accessible depuis l'extérieur du dispositif de maintien 1 lorsque la cellule photovoltaïque 5 y est maintenue. Cela permet alors de s'assurer que seul le bord périphérique 5C de la cellule photovoltaïque 5 peut être exposé à l'espèce de passivation pour le dépôt d'une couche de passivation (les autres parties de la cellule photovoltaïque 5 étant isolées grâce à la présence du premier joint d'étanchéité 15 et du deuxième joint d'étanchéité 25 qui forment une barrière à l'espèce de passivation utilisée).

Il est à noter qu'en pratique une faible surface des faces avant et arrière (le long du premier joint d'étanchéité et du deuxième joint d'étanchéité) peut également être exposée aux espèces de passivation pour le dépôt de la couche de passivation. Toutefois, grâce au premier joint d'étanchéité et au deuxième joint d'étanchéité, les métallisations et le coeur de la cellule photovoltaïque (i.e. le coeur des faces avant et arrière) sont protégées efficacement (c'est-à-dire que le dépôt de la couche de passivation n'atteint pas ces parties de la cellule photovoltaïque).

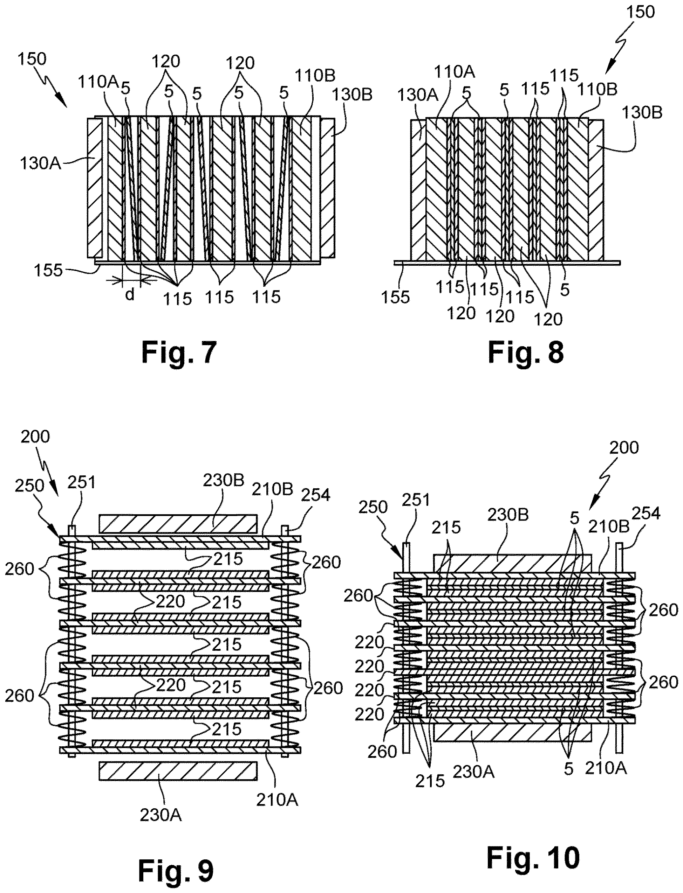

Le premier mode de réalisation de dispositif de maintien 1 est représenté selon une configuration verticale sur les figures 1 à 3. Il n'est bien entendu pas limité à cette configuration verticale et peut, en variante, être agencé selon une configuration horizontale (telle que représentée pour le troisième mode de réalisation sur les figures 7 et 8).

Dans une telle configuration horizontale, il peut être envisagé que la première partie de support et la deuxième partie de support soient maintenues par des portants verticaux (jouant alors le rôle de supports). Les moyens de compression selon l'invention sont configurés de telle manière que, bien entendu, dans une telle configuration horizontale, la cellule photovoltaïque ne glisse pas entre le premier joint d'étanchéité et le deuxième joint d'étanchéité. Elle est fermement maintenue entre les deux.

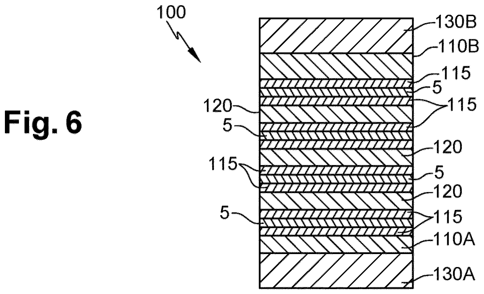

Les figures 5 et 6 représentent un deuxième mode de réalisation du dispositif de maintien 100 conforme à l'invention. La figure 5 représente le dispositif de maintien 100 selon ce deuxième mode de réalisation dans une position de chargement. La figure 6 représente le dispositif de maintien 100 selon ce deuxième mode de réalisation dans une position de compression.

Ce dispositif de maintien 100 selon ce deuxième mode de réalisation repose sur le même principe que celui décrit selon le premier mode de réalisation. La différence repose sur le fait que, dans ce deuxième mode de réalisation, le dispositif de maintien 100 permet de maintenir une pluralité de cellules photovoltaïques 5. Les cellules photovoltaïques 5 de cette pluralité présentent toutes globalement les mêmes formes et dimensions. Le pourtour de ces cellules photovoltaïques 5 est donc sensiblement similaire.

Seules les différences de ce deuxième mode de réalisation par rapport au premier mode de réalisation sont décrites en détails dans la suite.

Comme cela est visible sur les figures 5 et 6, le dispositif de maintien 100 comprend une pluralité de parties de support 110A, 110B, 120, une pluralité de joints d'étanchéité 115 et des moyens de compression 130A, 130B.

Chaque joint d'étanchéité 115 de la pluralité de joints d'étanchéité présentent les mêmes caractéristiques que le premier joint d'étanchéité 15 et le deuxième joint d'étanchéité 25 décrits pour le premier mode de réalisation. Ces caractéristiques ne sont donc pas décrites à nouveau ici.

La pluralité de parties de support 110A, 110B, 120 comprend des parties de support d'extrémité 110A, 110B et des parties de support intermédiaires 120.

Les deux parties de support d'extrémité 110A, 110B présentent respectivement les mêmes caractéristiques que la première partie de support 10 et la deuxième partie de support 20 décrites dans le premier mode de réalisation du dispositif de maintien 1. Elles ne sont donc pas décrites en détails à nouveau ici. Comme cela est visible sur les figures 5 et 6, ces parties de support d'extrémité 110A, 110B sont munies, uniquement sur l'une de leurs faces de support 110C, 110D, d'un joint d'étanchéité 115.

Au contraire, les parties de support intermédiaires 120 sont, elles, munies de deux joints d'étanchéité 115. Chaque partie de support intermédiaire 120 comprend, comme les parties de support d'extrémité 110A, 110B, la première partie de support 10 et la deuxième partie de support 20, deux faces de support 120A, 120B opposées.

Comme le montrent les figures 5 et 6, chaque face de support 120A, 120B est munie d'un joint d'étanchéité 115. En d'autres termes, chaque partie de support intermédiaire 120 est munie de deux joints d'étanchéité 115, un sur chaque face de support 120A, 120B. Comme pour le premier mode de réalisation, chaque joint d'étanchéité 115 est configuré pour venir en appui contre l'une des faces 5A, 5B de la cellule photovoltaïque 5 concernée.

Finalement, les parties de support intermédiaires 120 présentent les mêmes caractéristiques que les parties de support d'extrémité 110A, 110B, la première partie de support 10 et la deuxième partie de support 20, si ce n'est qu'elles sont munies, sur leurs deux faces de support 120A, 120B, d'un joint d'étanchéité 115 configuré pour venir en appui contre l'une des faces 5A, 5B des cellules photovoltaïques 5.

Afin que la pluralité de cellules photovoltaïques 5 soit maintenue dans le dispositif de maintien 100 à une position particulière (notamment pour le dépôt d'une couche de passivation décrit ci-après), le dispositif de maintien 100 comprend également les moyens de compression 130A, 130B.

Ces moyens de compression 130A, 130B sont similaires à ceux décrits dans le premier mode de réalisation mais adaptés à la configuration du deuxième mode de réalisation avec une pluralité de parties de support 110A, 110B, 120 et une pluralité de joints d'étanchéité 115 et de manière à maintenir une pluralité de cellules photovoltaïques 5.

Par exemple, dans le cas où les moyens de compression 130A, 130B comprennent deux pistons 130A, 130B, ces deux pistons 130A, 130B sont positionnés de part et d'autre des deux parties de support d'extrémité 110A, 110B.

Plus particulièrement, chacun des pistons 130A, 130B est positionné en contact de la face de support libre (c'est-à-dire sans joint d'étanchéité) de la partie de support d'extrémité 110A, 110B correspondante. Les deux pistons 130A, 130B exercent alors des forces de pression opposées et semblables en norme de manière à maintenir les cellules photovoltaïques 5 en appui serré contre les joints d'étanchéité 115 concernés.

Le dispositif de maintien 100 selon ce deuxième mode de réalisation comprend également des moyens de positionnement (non représentés sur les figures). Ici, aussi, ces moyens de positionnement sont similaires à ceux décrits précédemment pour le premier mode de réalisation si ce n'est qu'ils sont également adaptés à la configuration avec du deuxième mode de réalisation avec une pluralité de parties de support 110A, 110B, 120 et une pluralité de joints d'étanchéité 115 et de manière à maintenir une pluralité de cellules photovoltaïques 5.

Par exemple, il peut être prévu une pluralité d'ensemble d'éléments de guidage, chaque ensemble étant associé au positionnement de l'une des cellules photovoltaïques 5 de la pluralité de cellules photovoltaïques 5 à positionner.

Les figures 7 et 8 représentent un troisième mode de réalisation du dispositif de maintien 150 conforme à l'invention. La figure 7 représente le dispositif de maintien 150 selon ce troisième mode de réalisation dans une position de chargement. La figure 8 représente le dispositif de maintien 150 selon ce troisième mode de réalisation dans une position de compression.

Ce dispositif de maintien 150 selon ce troisième mode de réalisation repose sur le même principe que celui décrit selon le deuxième mode de réalisation. La différence repose sur le fait que, dans ce troisième mode de réalisation, le dispositif de maintien 150 est agencé selon une configuration horizontale.

La différence avec le deuxième mode de réalisation décrit précédemment repose notamment sur le fait, qu'en position de chargement (figure 7), le dispositif de maintien 150 comprend un moyen de support 155 permettant de maintenir les cellules photovoltaïques 5 lors de leur chargement dans le dispositif de maintien 150.

Ce moyen de support 155 comprend par exemple un rail configuré pour venir en butée contre les parties de support 110A, 110B, 120 de manière à retenir les cellules photovoltaïques 5 dans le dispositif de maintien 150 lors de leur chargement.

En variante ce moyen de support 155 peut être formé par une partie de l'ensemble des éléments de guidage. Cette partie de l'ensemble des éléments de guidage est par exemple alors positionnée sur le côté du dispositif de maintien 150 duquel les cellules photovoltaïques 5 insérées risqueraient de tomber. Cette partie de l'ensemble des éléments de guidage forme alors une butée pour l'un des côtés du bord périphérique 5C de chaque cellule photovoltaïque 5 insérée dans le dispositif de maintien 150.

Ce moyen de support 155 est par exemple amovible. Il peut par exemple être monté mobile sur le dispositif de maintien 150 entre une position d'utilisation, lors de chargement des cellules photovoltaïques 5 dans le dispositif de maintien 150, de manière à former une butée pour celles-ci, et une position de maintien lors de laquelle les cellules photovoltaïques 5 sont maintenues en appui serré entre les joints d'étanchéité 115. Dans cette position de maintien, le moyen de support 155 est par exemple positionné à distance des parties de support 110A, 110B, 120 (de sorte à ne plus être en contact avec elles).

Alors que dans les autres modes de réalisation décrits dans la présente demande, aucune contrainte d'espacement n'est imposée entre les parties de support, l'agencement horizontal de ce troisième mode de réalisation nécessite une condition supplémentaire.

En effet, afin d'éviter un basculement des cellules photovoltaïques lors de leur chargement (qui risquerait de les dégrader), la distance d entre deux parties de support 110A, 110B, 120 adjacentes est limitée. Cette distance d est par exemple inférieure à 10 fois l'épaisseur des cellules photovoltaïques 5. De préférence, cette distance d est inférieure à 5 fois l'épaisseur des cellules photovoltaïques 5.

Les figures 9 et 10 représentent un quatrième mode de réalisation du dispositif de maintien 200 conforme à l'invention. La figure 9 représente le dispositif de maintien 200 selon ce quatrième mode de réalisation dans une position de chargement. La figure 10 représente le dispositif de maintien 200 selon ce quatrième mode de réalisation dans une position de compression.

Ce dispositif de maintien 200 selon ce quatrième mode de réalisation repose sur le même principe que celui décrit selon le deuxième mode de réalisation. La différence repose sur le fait que, dans ce quatrième mode de réalisation, les moyens de compression 230A, 230B sont couplés à un système de support à ressort 250. Ce système de support à ressort 250 est configuré pour amortir le mouvement de compression et faciliter le retour à la position de chargement lorsque les moyens de compression 230A, 230B n'exercent plus l'effort de compression sur la pluralité des parties de support 210A, 210B, 220.

Le système de support à ressort 250 comprend ici quatre montants 251, 252, 253, 254 s'étendant entre les deux parties d'extrémité 210A, 210B. Ici, les quatre montants 251, 252, 253, 254 coopèrent avec les parties de support 210A, 210B, 220.

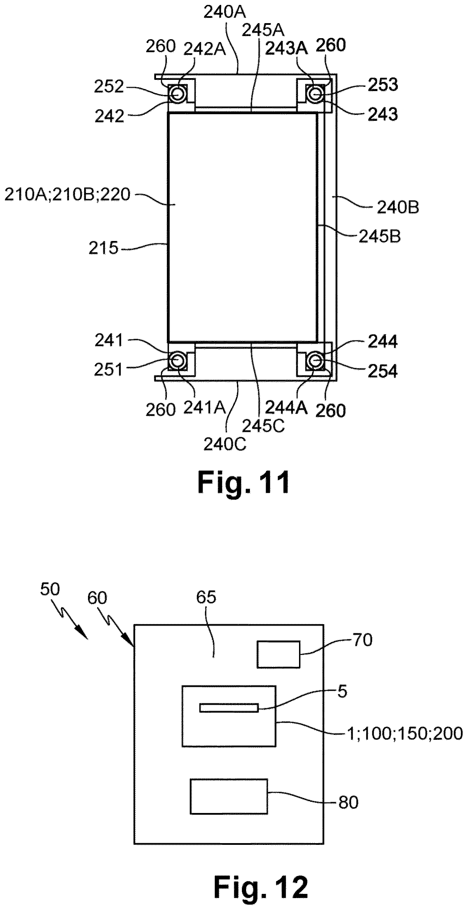

Pour cela, dans ce quatrième mode de réalisation, les parties de support 210A, 210B, 220 présentent une partie de prolongement 241, 242, 243, 244 au niveau de leurs coins afin de coopérer avec le système de support à ressort 250 (figure 11).

Plus particulièrement ici, comme cela est visible sur la figure 11, chaque partie de support 210A, 210B, 220 comprend, au niveau de chacun de ses coins une extension de matière, la partie de prolongement 241, 242, 243, 244. Chaque partie de prolongement 241, 242, 243, 244 comprend un orifice 241A, 242A, 243A, 244A, au travers duquel s'étend le montant 251, 252, 253, 254 concerné.

Comme cela est visible sur les figures 9 à 11, le système de support à ressort comprend également une pluralité de ressorts 260. Plus particulièrement, chaque montant 251, 252, 253, 254 est équipé d'au moins un ressort 260.

Ici, le système de support à ressort 250 comprend une pluralité de ressort 260. Chaque ressort 260 est positionné entre deux parties de support 210A, 210B, 220 adjacentes. Plus particulièrement, comme cela est visible sur la figure 11, les extrémités de chaque ressort 260 sont en appui sur les parties de prolongement 241, 242, 243, 244. En pratique, chacune des extrémités de chaque ressort est en appui, sur les parties de prolongement 241, 242, 243, 244, en périphérie de l'orifice 241A, 242A, 243A, 244A concerné.

Chaque ressort 260 est un ressort de compression, avec une raideur comprise entre 0,2 et 10 N/mm (Newton par millimètre).

De manière avantageuse dans ce quatrième mode de réalisation, grâce à ce système de support à ressort 250 (et à la pluralité de ressorts 260), chaque partie de support 210A, 210B, 220 coulisse le long des montants 251, 252, 253, 254, sous l'action de la pluralité de ressorts 260. Plus particulièrement, chaque partie de support 210A, 210B, 220 coulisse le long des montants 251, 252, 253, 254 entre la position de chargement et la position de compression du dispositif de maintien 200. En position de chargement, la pluralité de ressorts 260 est en position de repos, les cellules photovoltaïques 5 peuvent donc être introduites entre les parties de support 210A, 210B, 220. En position de compression, la pluralité de ressorts 260 est comprimée, permettant alors de maintenir en appui serré chaque cellule photovoltaïque 5 entre les deux joints d'étanchéité 215 concernés.

Le dispositif de maintien 200 selon ce quatrième mode de réalisation comprend également des moyens de positionnement 240A, 240B, 240C.

Comme cela est représenté sur la figure 11, ces moyens de positionnement 240A, 240B, 240C sont par exemple ici formés par les éléments de guidage 240A, 240B, 240C comme décrits précédemment dans le premier mode de réalisation (seuls trois éléments de guidage sur les quatre sont représentés sur la figure 11).

La différence avec le premier mode de réalisation repose sur la forme de ces éléments de guidage 240A, 240B, 240C. En effet ici, ils sont conformés pour tenir compte des parties de prolongement 241, 242, 243, 244. Comme le montre la figure 11, les éléments de guidage 240A, 240B, 240C, 240D sont ici tronqués au niveau des parties de prolongement 241, 242, 243, 244 de manière à être complémentaires en forme avec celles-ci. Cela garantit alors que le bord d'extrémité 245A, 245B, 245C puisse former une butée pour l'un des côtés du bord périphérique 5C de chaque cellule photovoltaïque 5 malgré la présence de ces parties de prolongement 241, 242, 243, 244.

Ainsi, grâce à leur forme adaptée à la configuration de ce quatrième mode de réalisation (avec la présence des montants 251, 252, 253, 254 et des parties de prolongement 241, 242, 243, 244), chaque élément de guidage 240A, 240B, 240C est positionné de telle manière que le bord d'extrémité 245A, 245B, 245C correspondant soit positionné en bordure des joints d'étanchéité 215. Autrement dit, chaque bord d'extrémité 245A, 245B, 245C est positionné le long du pourtour des joints d'étanchéité 215, de manière à délimiter un cadre de réception pour chaque cellule photovoltaïque 5 (chaque cadre de réception ainsi délimité correspond au positionnement précis recherché pour la cellule photovoltaïque 5 pour permettre l'alignement du pourtour de la cellule photovoltaïque 5 avec les joints d'étanchéité 215 tel que cela a été décrit précédemment).

Quel que soit le mode de réalisation du dispositif de maintien, ce dernier permet de maintenir la ou les cellules photovoltaïques 5 de sorte que seul le bord périphérique 5C de la cellule photovoltaïque 5 soit accessible depuis l'extérieur du dispositif de maintien lorsque la cellule photovoltaïque 5 y est maintenue. Cela permet alors de s'assurer que seul le bord périphérique 5C des cellules photovoltaïques 5 est exposé aux espèces de passivation pour le dépôt de la couche de passivation (les autres parties des cellules photovoltaïques 5 étant isolées grâce à la présence des joints d'étanchéité qui forment une barrière aux espèces de passivation utilisées).

Par ailleurs, les éléments formant le dispositif de maintien présentent les caractéristiques nécessaires pour supporter l'étape de passivation. Autrement dit, les différents éléments du dispositif de maintien présentent notamment des propriétés de résistance à des températures élevées (jusqu'à 200°C typiquement) et une faible perméabilité aux espèces de passivation utilisées pour la passivation de la cellule photovoltaïque décrite ci-après.

La présente invention concerne également un dispositif 50 de dépôt de couches minces sur au moins une cellule photovoltaïque 5.

La figure 12 représente un exemple du dispositif 50 de dépôt de couches minces conforme à la présente invention. Ce dispositif 50 permet notamment le dépôt d'au moins une couche de passivation sur les cellules photovoltaïques 5.

Comme le montre cette figure, ce dispositif 50 de dépôt de couches minces comprend une enceinte 60 de dépôt de couches minces, le dispositif de maintien 1 ; 100; 150; 200 tel que décrit précédemment muni d'au moins une cellule photovoltaïque 5 et des moyens d'injection 70 d'au moins une espèce de passivation.

L'enceinte 60 de dépôt de couches minces (et notamment d'au moins une couche de passivation) comprend par exemple un ensemble de parois permettant de délimiter un logement d'accueil 65 du dispositif de maintien 1 ; 100 ; 150 ; 200. Ce logement d'accueil 65 est également celui dans lequel les espèces de passivation sont introduites de manière à conduire à la formation de couches de passivation sur les cellules photovoltaïques 5 (et en particulier sur le bord périphérique 5C de chaque cellule photovoltaïque 5). Cette enceinte 60 de dépôt de couches minces est par exemple une enceinte de dépôt sous vide.

Cette enceinte 60 de dépôt de couches minces est dimensionnée pour permettre d'accueillir le dispositif de maintien 1 ; 100 ; 150 ; 250, tel que décrit précédemment, muni d'une ou plusieurs cellules photovoltaïques 5.

Par ailleurs, afin de ne pas être endommagée pendant le processus de passivation (c'est-à-dire pendant l'injection des espèces de passivation de manière à former les couches de passivation), les parois internes de l'enceinte 60 de dépôt de couches minces présentent notamment des propriétés de résistance à des températures élevées (jusqu'à 200°C typiquement) et une faible perméabilité aux espèces de passivation utilisées pendant ce processus de passivation.

Afin de permettre la formation de couches de passivation sur les cellules photovoltaïques 5, le dispositif 50 de dépôt de couches minces comprend les moyens d'injection 70 d'au moins une espèce de passivation. De préférence, cette espèce de passivation se présente sous la forme d'un gaz.

Dans la présente invention, une couche de passivation est par exemple formée par dépôt de couches atomiques (ou ALD pour « *Atomic Layer Deposition* » selon l'acronyme d'origine anglo-saxonne couramment utilisé). Selon cette méthode, différents gaz précurseurs sont introduits dans l'enceinte 60 de dépôt de couches minces et acheminés vers les différentes zones (ici le bord périphérique 5C de chaque cellule photovoltaïque 5) sur lesquelles une ou plusieurs couches atomiques doivent être déposées.

En pratique, une couche atomique est formée sur une zone concernée (i.e. ici le bord périphérique 5C de chaque cellule photovoltaïque 5) en exposant cette zone au flux d'un premier gaz précurseur injecté, dans l'enceinte 60 de dépôt de couches minces, par les moyens d'injection 70. Ce premier gaz précurseur réagit avec les terminaisons de la zone concernée et forme une monocouche contenant d'autres terminaisons (groupes réactifs). Un deuxième gaz précurseur (également injecté par les moyens d'injection 70) introduit ensuite réagit avec les terminaisons de la monocouche formée (à l'issue de l'injection du premier gaz précurseur) de manière à former la couche de passivation souhaitée.

En pratique, les moyens d'injection 70 sont par exemple formés par une tête d'injection (non représentée) permettant l'introduction du gaz dans l'enceinte 60 de dépôt de couches minces. Les conditions de dépôt (telles que la position de la tête d'injection, les débits des gaz, la concentration des précurseurs et la température) et les dimensions de la tête d'injections sont avantageusement choisies de façon à ce que la couche de passivation soit formée au niveau du bord périphérique 5C de chaque cellule photovoltaïque 5 maintenue dans le dispositif de maintien 1 ; 100 ; 150 ; 200.

De manière préférentielle, le matériau de la couche de passivation est par exemple de l'alumine (Al₂O₃), du dioxyde de silicium (SiO₂), du nitrure de silicium (Si₃N₄) ou du silicium amorphe hydrogéné (a-Siₓ :H).

L'épaisseur de la couche de passivation est de l'ordre de quelques nanomètres (nm) à quelques dizaines de nanomètres. Par exemple, dans le cas de l'alumine, l'épaisseur de la couche de passivation est supérieure à 5 nm, de préférence comprise entre 5 et 15 nm. Dans le cas du nitrure de silicium amorphe hydrogéné, l'épaisseur de la couche de passivation est de préférence comprise entre 5 et 15 nm.

En variante, l'espèce de passivation peut se présenter sous la forme d'une solution liquide vaporisée. Il s'agit par exemple d'une solution liquide de polymère vaporisée. Le polymère est ici un fluoropolymère tel que le Nafion^{™}.

Grâce au dispositif de maintien 1 ; 100 ; 150 ; 200 décrit précédemment, seul le bord périphérique 5C de chaque cellule photovoltaïque 5 maintenue est exposé aux espèces de passivation injectées dans l'enceinte 60 de dépôt de couches minces. Ainsi, de manière avantageuse, la couche de passivation est formée uniquement sur le bord périphérique 5C de chaque cellule photovoltaïque 5 maintenue dans le dispositif de maintien 1 ; 100 ; 150 ; 200 (lorsque les espèces de passivation injectées dans l'enceinte 60 de dépôt de couches minces affleurent le bord périphérique 5C de chaque cellule photovoltaïque 5). La localisation du dépôt uniquement sur le bord périphérique (et non sur la totalité des faces de chaque cellule photovoltaïque) permet de faciliter l'étape d'interconnexion ultérieure des cellules photovoltaïques. Cela permet alors d'éviter la dégradation des performances électriques des cellules photovoltaïques.

En variante, le dépôt de la couche de passivation peut être réalisé par d'autres méthodes. Par exemple, des méthodes de dépôt physique par phase vapeur (ou PVD pour « *Physical Vapor Deposition* » selon l'acronyme d'origine anglo-saxonne) ou de dépôt chimique en phase vapeur (ou CVD pour « *Chemical Vapor Deposition* ») peuvent être utilisées.

En variante encore, une méthode chimique de dépôt en phase liquide peut être utilisée.

En variante encore, des méthodes de dépôt sur la base de plasma peuvent également être utilisés. Dans un tel cas, les matériaux utilisés, en particulier pour les parties de support, doivent être adaptés pour être conducteurs. Pour cela, il est notamment possible d'utiliser du graphite.

De manière avantageuse, afin de définir un flux directionnel autour du dispositif de maintien 1 ; 100 ; 150 ; 200 dans le logement d'accueil 65 de l'enceinte 60 de dépôt de couches minces, cette dernière comprend également un système de pompage 80.

Ce système de pompage 80 est configuré pour permettre la circulation des espèces de passivation, autour du dispositif de maintien 1 ; 100 ; 150 ; 200, selon un flux directionnel. Le flux directionnel est ici défini d'une extrémité à une autre du dispositif de maintien 1 ; 100 ; 150 ; 200. Par exemple, la circulation des espèces de passivation s'effectue, dans l'enceinte 60 de dépôt de couches minces, depuis l'une des parties de support d'extrémité à l'autre.

Le flux directionnel est donc imposé, dans l'enceinte 60 de dépôt de couches minces, entre l'introduction des espèces de passivation, par les moyens d'injection 70, et l'aspiration générée par le système de pompage 80. Cela permet notamment d'assurer une exposition au(x) espèce(s) de passivation semblable pour l'ensemble des cellules photovoltaïques 5, sur l'ensemble de leur bord périphérique 5C.

### Procédé de maintien d'au moins une cellule photovoltaïque

La présente invention concerne également un procédé de maintien d'au moins une cellule photovoltaïque 5 dans le dispositif de maintien 1 ; 100 ; 150 ; 200 (pour déposer ensuite une couche de passivation sur cette cellule photovoltaïque 5).

Le procédé de maintien comprend tout d'abord une étape de fourniture d'au moins deux parties de support. Il s'agit par exemple de la première partie de support 10 et de la deuxième partie de support 20 décrites précédemment. Ces parties de support sont munies des joints d'étanchéité conformés comme précédemment décrit.

Le procédé de maintien comprend ensuite une étape de positionnement de la cellule photovoltaïque 5 entre les deux parties de support, et plus particulièrement entre les deux joints respectifs formés sur les deux parties de support concernées.

De manière optionnelle, cette étape de positionnement peut comprendre une sous-étape d'ajustement de la position de la cellule photovoltaïque 5 de manière à assurer un positionnement précis. Cette sous-étape est mise en oeuvre par les moyens de positionnement décrits précédemment.

Le procédé de maintien comprend enfin une étape de compression d'un empilement formé par les deux parties de support entre lesquelles est positionnée la cellule photovoltaïque 5 de manière à maintenir la cellule photovoltaïque 5 en appui serré contre les deux joints d'étanchéité respectifs.

Dans le cas d'une mise en oeuvre automatisée du procédé de maintien, l'étape de positionnement comprend le positionnement de la première partie de support, puis de la cellule photovoltaïque (sur le premier joint d'étanchéité de la première partie de support positionnée), puis de la deuxième partie de support (avec le deuxième joint d'étanchéité en contact avec la cellule photovoltaïque). Dans ce cas, ce positionnement est par exemple réalisé par un bras robotisé qui positionne successivement chacune de la première partie de support, de la cellule photovoltaïque et de la deuxième partie de support.

### Procédé de passivation d'au moins une cellule photovoltaïque

La présente invention concerne enfin un procédé de passivation d'au moins une cellule photovoltaïque 5.

D'une manière générale, ce procédé de passivation comprend les étapes suivantes :
- maintien de la cellule photovoltaïque 5 dans le dispositif de maintien 1 ; 100 ; 150 ; 200 selon le procédé de maintien,
- positionnement du dispositif de maintien 1 ; 100 ; 150 ; 200 muni de la cellule photovoltaïque 5 dans le logement d'accueil 65 de l'enceinte 60 de dépôt de couches minces,
- injection d'au moins une espèce de passivation dans l'enceinte 60 de dépôt de couches minces de manière à former la couche de passivation sur le bord périphérique 5C de la cellule photovoltaïque 5 lorsque que l'espèce de passivation injectée affleure ce bord périphérique 5C.

Grâce au dispositif de maintien 1; 100; 150; 200 tel que décrit précédemment, lorsque la cellule photovoltaïque 5 est maintenue dans le dispositif de maintien, seul le bord périphérique 5C de la cellule photovoltaïque 5 est visible et accessible depuis l'extérieur du dispositif de maintien (dans lequel est introduit la cellule photovoltaïque 5). En d'autres termes, le premier joint d'étanchéité 15 et le deuxième joint d'étanchéité 25 isole la première face 5A et la deuxième face 5B de la cellule photovoltaïque 5, placée dans le dispositif de maintien, de l'extérieur du dispositif de maintien. Ainsi, lors de l'injection des espèces de passivation de l'enceinte 60 de dépôt de couches minces, la couche de passivation ne se forme que sur le bord périphérique 5C de la cellule photovoltaïque 5 (lorsque que l'espèce de passivation injectée affleure ce bord périphérique 5C et réagit avec ce bord périphérique).

La présente invention est décrite pour des sous-cellules mais peut également être mise en oeuvre avec des cellules photovoltaïques de pleine taille. En particulier, pour des technologies de cellules avancées telles que les cellules à hétérojonction (HET), il peut être utile d'améliorer la passivation existante des bords de cellule en formant une nouvelle couche de passivation.

## Revendications

1. Dispositif de maintien (1 ; 100 ; 150 ; 200) d'au moins une cellule photovoltaïque (5) pour former une couche de passivation sur une partie de ladite cellule photovoltaïque (5), la cellule photovoltaïque (5) comprenant une première face (5A), une deuxième face (5B), opposée à ladite première face (5A), et un bord périphérique (5C) reliant la première face (5A) et la deuxième face (5B), le dispositif de maintien (1 ; 100 ; 150 ; 200) comprenant :
- une première partie de support (10 ; 110A, 110B, 120 ; 210A, 210B, 220) comprenant une première face de support (10A) et une deuxième face de support (10B) opposée à ladite première face de support (10A) , la première face de support (10A) étant munie d'un premier joint d'étanchéité (15 ; 115 ; 215) conformé selon un pourtour de la cellule photovoltaïque (5),
- une deuxième partie de support (20 ; 110A, 110B, 120 ; 210A, 210B, 220) comprenant une troisième face de support (20A ; 110D) et une quatrième face de support (20B) opposée à ladite troisième face de support (20A ; 110D), la troisième face de support (20A ; 110D) étant munie d'un deuxième joint d'étanchéité (25 ; 115 ; 215) conformé selon le pourtour de la cellule photovoltaïque (5), et
- des moyens de compression (30A, 30B ; 30C ; 130A, 130B ; 230A, 230B) configurés pour maintenir la cellule photovoltaïque (5) en appui serré contre le premier joint d'étanchéité (15 ; 115 ; 215) et contre le deuxième joint d'étanchéité (25 ; 115 ; 215).

2. Dispositif de maintien (1 ; 100 ; 150 ; 200) selon la revendication 1, comprenant également des moyens de positionnement (40A, 40B, 40C, 40D ; 240A, 240B, 240C) de la cellule photovoltaïque (5) entre la première partie de support (10 ; 110A, 110B, 120 ; 210A, 210B, 220) et la deuxième partie de support (20; 110A, 110B, 120 ; 210A, 210B, 220).

3. Dispositif de maintien (1 ; 100 ; 150 ; 200) selon la revendication 2, dans lequel les moyens de positionnement (40A, 40B, 40C, 40D ; 240A, 240B, 240C) comprennent des éléments de guidage positionnés en bordure du premier joint d'étanchéité (15 ; 115 ; 215) et/ou du deuxième joint d'étanchéité (25 ; 115 ; 215) de manière à positionner le pourtour de la cellule photovoltaïque (5) en regard du premier joint d'étanchéité (15 ; 115 ; 215) et du deuxième joint d'étanchéité (25 ; 115 ; 215).

4. Dispositif de maintien (1 ; 100 ; 150 ; 200) selon la revendication 2 ou 3, dans lequel les moyens de positionnement comprennent au moins un bras robotisé configuré pour positionner la cellule photovoltaïque (5) entre la première partie de support (10 ; 110A, 110B, 120 ; 210A, 210B, 220) et la deuxième partie de support (20 ; 110A, 110B, 120 ; 210A, 210B, 220) de sorte que le pourtour de la cellule photovoltaïque (5) soit positionné en regard du premier joint d'étanchéité (15 ; 115 ; 215) et du deuxième joint d'étanchéité (25 ; 115 ; 215).

5. Dispositif de maintien (1 ; 100 ; 150 ; 200) selon l'une quelconque des revendications 1 à 4, dans lequel la première face de support (10A ; 110C) de la première partie de support (10 ; 110A, 110B, 120 ; 210A, 210B, 220) comprend une rainure (16) conformée pour fixer le premier joint d'étanchéité (15 ; 115 ; 215) sur la première partie de support (10 ; 110A, 110B, 120 ; 210A, 210B, 220).

6. Dispositif de maintien (1 ; 100 ; 150 ; 200) selon l'une quelconque des revendications 1 à 5, dans lequel la troisième face de support (20A ; 110D) de la deuxième partie de support (20 ; 110A, 110B, 120 ; 210A, 210B, 220) comprend une rainure (26) conformée pour fixer le deuxième joint d'étanchéité (25 ; 115 ; 215) sur la deuxième partie de support (20 ; 110A, 110B, 120 ; 210A, 210B, 220).

7. Dispositif de maintien (1 ; 100 ; 150 ; 200) selon l'une quelconque des revendications 1 à 6, dans lequel les moyens de compression (30A, 30B ; 30C ; 130A, 130B ; 230A, 230B) sont configurés pour exercer une force de pression supérieure à 2 Newtons, de préférence comprise entre 2 et 10 Newtons, pour maintenir la cellule photovoltaïque (5) en appui serré contre le premier joint d'étanchéité (15 ; 115 ; 215) et contre le deuxième joint d'étanchéité (25 ; 115 ; 215).

8. Dispositif de maintien (1 ; 100 ; 150 ; 200) selon l'une quelconque des revendications 1 à 7, dans lequel les moyens de compression (30A, 30B ; 130A, 130B ; 230A, 230B) comprennent deux pistons positionnés de part et d'autre de la première partie de support (10 ; 110A, 110B, 120 ; 210A, 210B, 220) et de la deuxième partie de support (20 ; 110A, 110B, 120 ; 210A, 210B, 220).

9. Dispositif de maintien (1 ; 100 ; 150 ; 200) selon l'une quelconque des revendications 1 à 8 prise dans la dépendance de la revendication 7, dans lequel les moyens de compression (30C) comprennent un élément de charge positionné sur la deuxième partie de support (20 ; 110A, 110B, 120 ; 210A, 210B, 220) de manière à exercer ladite force de pression.

10. Dispositif de maintien (1 ; 100 ; 150 ; 200) selon l'une quelconque des revendications 1 à 9, dans lequel le premier joint d'étanchéité (15 ; 115 ; 215) et le deuxième joint d'étanchéité (25 ; 115 ; 215) sont formés dans un matériau polymère souple.

11. Dispositif de maintien (100 ; 150 ; 200) selon l'une quelconque des revendications 1 à 10, comprenant également :
- une troisième partie de support (120 ; 220) comprenant une cinquième face de support et une sixième face de support opposée à ladite cinquième face de support, la cinquième face de support étant munie d'un troisième joint d'étanchéité (115 ; 215) conformé selon un autre pourtour d'une autre cellule photovoltaïque (5), ledit autre pourtour de l'autre cellule photovoltaïque (5) étant similaire au pourtour de la cellule photovoltaïque (5), ladite autre cellule photovoltaïque (5) comprenant une autre première face, une autre deuxième face, opposée à ladite autre première face, et un autre bord périphérique reliant l'autre première face et l'autre deuxième face,
la quatrième face de support de la deuxième partie de support étant munie d'un quatrième joint d'étanchéité (115 ; 215) conformé selon le pourtour de l'autre cellule photovoltaïque (5),
les moyens de compression (130A, 130B ; 230A, 230B) étant configurés pour maintenir l'autre cellule photovoltaïque (5) en appui serré contre le troisième joint d'étanchéité (115 ; 215) et contre le quatrième joint d'étanchéité (115 ; 215).

12. Dispositif (50) de dépôt de couches minces, et notamment d'une couche de passivation, sur au moins une partie d'une cellule photovoltaïque (5) comprenant :
- un dispositif de maintien (1; 100; 150; 200) selon l'une quelconque des revendications 1 à 11,
- au moins une cellule photovoltaïque (5) positionnée dans le dispositif de maintien (1 ; 100 ; 150 ; 200),
- une enceinte (60) de dépôt de couches minces comprenant une paroi latérale délimitant un logement d'accueil (65) pour le dispositif de maintien (1 ; 100 ; 150 ; 200) dans lequel est positionnée ladite cellule photovoltaïque (5), et
- des moyens d'injection (70) d'au moins une espèce de passivation permettant de former une couche de passivation sur le bord périphérique (5C) de la cellule photovoltaïque (5) lorsque l'espèce de passivation affleure le bord périphérique (5C) de la cellule photovoltaïque (5).

13. Dispositif (50) de dépôt de couches minces selon la revendication 12, comprenant également des moyens de pompage (80) de l'espèce de passivation configurés pour permettre la circulation de l'espèce de passivation autour du dispositif de maintien (1 ; 100 ; 150 ; 200) selon un flux directionnel.

14. Procédé de maintien d'au moins une cellule photovoltaïque (5) comprenant une première face (5A), une deuxième face (5B), opposée à ladite première face (5A), et un bord périphérique (5C) reliant la première face (5A) et la deuxième face (5B), le procédé comprenant des étapes de :
- fourniture d'une première partie de support (10 ; 110A, 110B, 120 ; 210A, 210B, 220) comprenant une première face de support (10A ; 110C) et une deuxième face de support opposée à ladite première face de support (10A ; 110C), la première face de support (10A ; 110C) étant munie d'un premier joint d'étanchéité (15 ; 115 ; 215) conformé selon un pourtour de la cellule photovoltaïque (5),
- fourniture d'une deuxième partie de support (20 ; 110A, 110B, 120 ; 210A, 210B, 220) comprenant une troisième face de support (20A ; 110D) et une quatrième face de support opposée à ladite troisième face de support (20A ; 110D), la troisième face de support (20A ; 110D) étant munie d'un deuxième joint d'étanchéité (25 ; 115 ; 215) conformé selon le pourtour de la cellule photovoltaïque (5),
- positionnement de la cellule photovoltaïque (5) entre la première partie de support (10 ; 110A, 110B, 120 ; 210A, 210B, 220) et la deuxième partie de support (20 ; 110A, 110B, 120 ; 210A, 210B, 220), et
- compression d'un empilement formé par la première partie de support (10 ; 110A, 110B, 120 ; 210A, 210B, 220), la cellule photovoltaïque (5) et la deuxième partie de support (20 ; 110A, 110B, 120 ; 210A, 210B, 220) de manière à maintenir la cellule photovoltaïque (5) en appui serré contre le premier joint d'étanchéité (15 ; 115 ; 215) et contre le deuxième joint d'étanchéité (15 ; 115 ; 215).

15. Procédé de maintien selon la revendication 14, dans lequel l'étape de positionnement comprend le positionnement successif de la première partie de support (10 ; 110A, 110B, 120 ; 210A, 210B, 220), de la cellule photovoltaïque (5) et de la deuxième partie de support (20 ; 110A, 110B, 120 ; 210A, 210B, 220).

16. Procédé de passivation d'au moins une cellule photovoltaïque (5) comprenant des étapes de :
- maintien de la cellule photovoltaïque (5) dans un dispositif de maintien (1 ; 100 ; 150 ; 200) selon un procédé de maintien selon la revendication 14 ou 15,
- positionnement du dispositif de maintien (1 ; 100 ; 150 ; 200) muni de la cellule photovoltaïque (5) dans une enceinte (60) de dépôt de couches minces, et
- injection d'au moins une espèce de passivation dans l'enceinte (60) de dépôt de couches minces de manière à former une couche de passivation sur un bord périphérique (5C) de la cellule photovoltaïque (5) lorsque l'espèce de passivation affleure le bord périphérique (5C) de la cellule photovoltaïque (5).
